# EUROPÄISCHE PATENTSCHRIFT

(11) **EP 0 635 837 B1**
(45) Veröffentlichungstag und Bekanntmachung des Hinweises auf die Patenterteilung: **19.05.1999**
(21) Anmeldenummer: 94109984.8
(22) Anmeldetag: 28.06.1994
(51) Int. Cl.: G11C 5/14, G11C 11/407

(54) **Ladungspumpe**
Charge pump
Pompe à charges

(30) Priorität: 23.07.1993 DE 4324855
(43) Veröffentlichungstag der Anmeldung: 25.01.1995
(73) Patentinhaber: SIEMENS AKTIENGESELLSCHAFT, 80333 München (DE)
(72) Erfinder: Savignac, Dominique, Dr. rer. nat., D-85737 München (DE); Gleis, Dieter, Dr. Ing., D-83109 Grosskarolinenfeld (DE); Menke, Manfred, D-80799 München (DE)

(56) Entgegenhaltungen:
- EP-A- 0 472 095
- 1992 SYMPOSIUM ON VLSI CIRCUITS DIGEST OF TECHNICAL PAPERS, Juni 1992, SEATTLE, Seiten 64-65, XP000342489 LEE ET AL.: "A 35 NS 64 MB DRAM USING ON-CHIP BOOSTED POWER SUPPLY"

## Beschreibung

Die Erfindung betrifft eine Ladungspumpe zur Erzeugung einer erhöhten, über der Versorgungsspannung liegenden Spannung.

Ladungspumpen werden in elektronischen Schaltkreisen dort eingesetzt, wo Schaltungsteile mit einer Spannung versorgt oder gesteuert werden sollen, die größer als die Versorgungsspannung der Gesamtschaltung ist. Solche Spannungen werden beispielsweise bei dynamischen Speichern (DRAM) benötigt. Die Speicherzelle eines DRAM enthält üblicherweise eine die Information speicnernde Kapazität, auf die über einen als Transfergatter geschalteten MOS-Transistor, meist vom n-Leitungstyp, zugegriffen wird. Die Spannung der mit dem Gate-Anschluß des Auswanltransistors verbundener Wortleitung muß über der Versorgungsspannung des Bausteins liegen, um eine zu speichernde Information sicher schreiben zu können. Außerdem darf die Wortleitungsspannung aus Gründen der Zuverlässigkeit einen maximalen Wert nicht überschreiten.

Eine Ladungspumpe zum Aufladen einer Speicherkapazität zur Erzeugung einer erhöhten Spannung gemäß des Oberbegriffs des Anspruchs 1 ist aus der Veröffentlichung "An Experimental 1.5-V 64-Mb DRAM", Nakagome, Y. et al, IEEE Journal of Solid State Circuits, Band 26, Nr. 4, April 1991, p. 465-472, bekannt. Die Wortleitungen werden in der aktiven Phase durch Ladungstransfer aus der Speicherkapazität geladen und mit einem kleineren zweistufigen Ladungsschieber auf den vollen erhöhten Spannungspegel gebracht. Dabei wird in der Ladungspumpe zwischen der Pumpschaltung und der Speicherkapazität ein n-Kanal-MOS-Transistor als Schalter verwendet. Zur Steuerung dieses Transfer-Transistors werden Spannungen verwendet, die höher als die erzeugte erhöhte Wortleitungsspannung sind. Bei ungünstigen Betriebszuständen kann dies zur Zerstörung der Ladungspumpe führen. Dabei werden offensichtlich keine Maßnahmen getroffen, um die maximale Spannung zu begrenzen. Außerdem wird die Spannung an den Schaltungsknoten zwischen dem n-Kanal-MOS-Transistor und einer Schiebekapazität eingefroren. Beim Absinken der Versorgungsspannung kann noch innerhalb des zulässigen Schwankungsbereichs die Pumpfunktion der Ladungspumpe unwirksam werden, da der n-Kanal-MOS-Transistor nicht mehr vollständig gesperrt ist.

Die Aufgabe der vorliegenden Erfindung ist es, eine Ladungspumpe zur Erzeugung einer erhöhten Spannung anzugeben, die in allen Betriebszuständen zuverlässig arbeitet.

Dies wird durch eine Ladungspumpe gemäß den Merkmalen des Patentanspruchs 1 gelöst.

Vorteilhafte Weiterbildungen sind in den Unteransprüchen angegeben.

Der Transfertransistor zwischen der Schiebekapazität und der Speicherkapazität der Ladungspumpe ist als p-Kanal-Transistor ausgeführt. Dies hat den Vorteil, daß über der Ausgangsspannung liegenden Steuerspannungen nicht benötigt werden. Im Gegensatz zu bisherigen Lösungen wird die Wanne des p-Kanal-MOS-Transistors nicht angeschlossen. Bei kleiner Dimensionierung der Wanne und entsprechend niedriger Wannenkapazität kann das Potential der Wanne mit nur geringer Verzögerung dem mit der Schiebekapazität verbundenen Anschluß des Transistors folgen. Dadurch wird vorteilhafterweise die Strominjektion ins Substrat minimiert. Dies könnte bei DRAM-Bausteinen sonst zur Zerstörung der in den Speicherkapazitäten gespeicherten Daten führen. Durch einen als MOS-Diode geschalteten Transistor innerhalb der Wanne wird das Potential der Wanne nach oben begrenzt. Diese Lösung ist platzsparend.

Die Erfindung wird im folgenden anhand der in den Figuren dargestellten Ausführungsbeispiele näher erläutert. Es zeigen
- Figur 1: das Prinzipschaltbild einer Gegentakt-Ladungspumpe zusammen mit einem Signaldiagram,
- Figur 2: die detaillierte Schaltung einer Pumpenhälfte zusammen mit einem Signaldiagramm,
- Figur 3: den Querschnitt durch den p-Kanal-MOS-Transistor zwischen Schiebekapazität und Speicherkapazität und
- Figur 4: das Schaltbild für einen Oszillator und eine Impulsformereinrichtung.

Die in Figur la gezeigte Ladungspumpe enthält zwei identische Hälften 1, 2, die im Gegentakt betrieben werden. Die Ladungspumpenhälften 1, 2 sind mit einem Anschluß 6 einer Speicherkapazität 5 verbunden. Der andere Anschluß der Speicherkapazität 5 liegt auf Bezugspotential VSS (Masse). Am Anschluß 6 kann die nach dem Pumpen über einem Versorgungspotential VDD liegende Ausgangsspannung A abgegriffen werden. Der Anschluß 6 wird beispielsweise über Schalteinrichtungen mit ausgewählten Wortleitungspfaden eines DRAMs bei einem Lese- oder Schreibzyklus verbunden. Zur Gegentaktsteuerung der Schaltungshälften 1, 2 ist ein über ein Steuersignal CTRL ein- und ausscnaltbarer Oszillator 3 vorgesehen, dessen Ausgangssignale in einer Impulsformereinrichtung 4 zur Steuerung der Ladungspumpenhälften zeitrichtig erzeugt werden. Die Ladungspumpenhälfte 1 enthält im einzelnen: Einen p-Kanal-MOS-Transistor 10, der als Transfer-Transistor zwischen den Anschluß 6 und eine Schiebekapazität 11 geschaltet ist. Die Schiebekapazität 11 ist vorzugsweise durch einen n-Kanal-MOS-Transistor realisiert. Zwischen den mit dem Transistor 10 verbundenen Anschluß 13 der Kapazität 11 und das Versorgungspotential VDD ist die Drain-Source-Strecke eines Vorladetransistors 12 vom n-Leitungstyp geschaltet. Der Gate-Anschluß des Transistors 10 wird von einem Signal B1 gesteuert, dessen L-Pegel beim Potential VSS und dessen H-Pegel beim Potential des Ausgangssignals A liegt. Der erhöhte H-Pegel des Signals B1 wird in einem Pegelwandler 14 erzeugt. Der Gate-Anschluß des Transistors 12 wird von einem Signal C1 gesteuert, dessen H-Pegel oberhalb des Versorgungspotentials VDD liegt und dessen L-Pegel vorzugsweise etwas über dem Versorgungspotential VSS liegt. Die Signalpegel des Signals C1 werden in einer Einrichtung 15 aus von der Impulsformereinrichtung 4 gelieferten Steuersignalen erzeugt. Der von der Speicherkapazität 5 abgewandte Anschluß 16 der Schiebekapazität 11 wird von einem Signal D1 gesteuert, das von der Impulsformereinrichtung 4 bereitgestellt wird. Die andere Ladungspumpenhälfte 2 ist identisch aufgebaut, wird jedoch von versetzt liegenden entsprechenden Steuersignalen B2, C2, D2 gesteuert, so daß ein Gegentaktbetrieb erreicht wird.

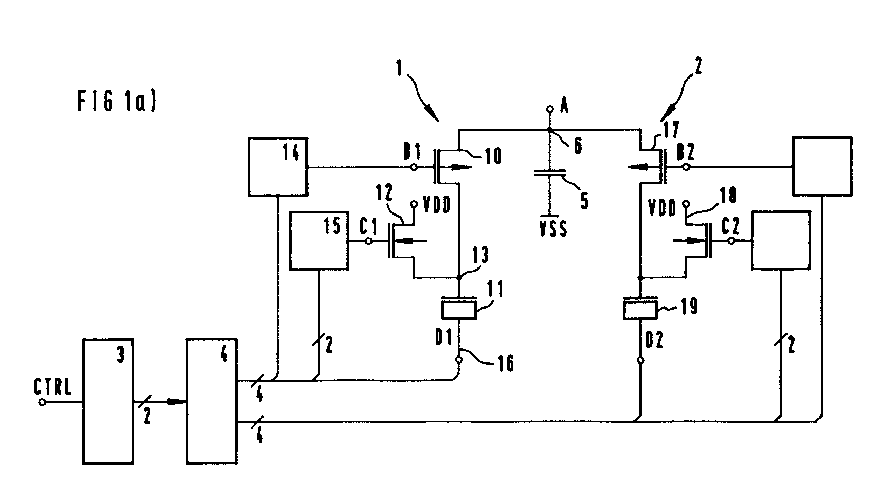

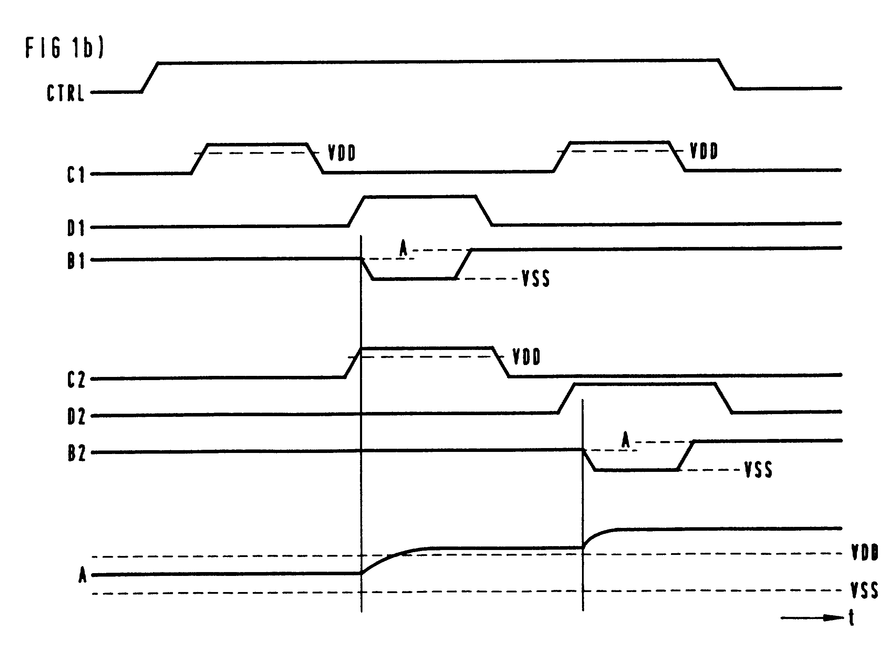

In Zusammenhang mit dem in Figur 1b gezeigten Zeitdiagramm der Steuersignale wird im folgenden die Funktionsweise der in der Figur la gezeigten Ladungspumpe beschrieben: Mit der ansteigenden Signalflanke des Signals CTRL wird der Oszillator 3 eingeschaltet. Durch die Impulsformereinrichtung 4 und die Einrichtungen 14, 15 werden die entsprechenden Steuersignale B1, C1, D1 bzw. B2, C2, D2 abgeleitet. In einem ersten Schritt wird durch einen H-Pegel des Signals C1, der über dem Versorgungspotential VDD liegt, der Transistor 12 eingeschaltet, so daß die Schiebekapazität 11 auf das Potential VDD vorgeladen wird. Durch die Erhöhung des H-Pegels des Signals C1 über das Versorgungspotential VDD wird die Schwellenspannung des Transistors 12 ausgeglichen. Der Transistor 10 ist dabei gesperrt. In einem zweiten Schritt wird durch einen H-Pegel des Signals D1 das Potential des Anschlusses 16 der Speicherkapazität 11 angehoben. Etwa gleichzeitig wird der Transistor 10 leitend gesteuert, indem das Signal B1 auf einen L-Pegel gesetzt wird. Dadurch steigt das Potential am Knoten 13 über das Potential A am Knoten 6, so daß die Speicherkapazität 5 durch Ladungstransfer aus der Schiebekapazität 11 aufgeladen wird. Der Transistor 12 ist dabei gesperrt. Während dieser Phase wird in der Schaltungshälfte 2 der Transistor 18 leitend gesteuert, um die Schiebekapazität 19 aufzuladen. Nachfolgend wird durch eine weitere H-Pegelphase des Signals C1 die Schiebekapazität 11 aufgeladen, während in der Schaltungshälfte 2 der Schiebevorgang durchgeführt wird. Das Pumpen wird solange fortgeführt, bis das Signal CTRL auf L zurückgeht. Dies kann beispielsweise dadurch erreicht werden, daß das Potential A am Ausgang 6 von einer Steuerungseinrichtung überwacht wird, wobei beim Überschreiten einer Pegelschwelle das Signal CTRL rückgesetzt wird.

Dadurch daß die H-Pegel der Signale B1, B2, die die Transfer-Transistoren 10, 17 steuern, gleich dem Ausgangssignal A sind, sind die Transistoren 10, 17 während der Vorladephase der Schiebekapazitäten 11 bzw. 19 sicher gesperrt. Durch die Vorladung der Schiebekapazitäten 11, 19 mit dem momentanen Versorgungspotential VDD ist auch bei einer Versorgungspotentialschwankung, wenn z.B. der Versorgungspotentialpegel VDD an der unteren Schwankungsgrenze liegt, eine einwandfreie Funktion gewährleistet. Durcn die Benutzung von zwei zeitversetzt arbeitenden Pumpen wird der Stromverbrauch über eine längere Zeit verteilt, so daß für die Schaltungen der Ladungspumpe und weiterer Schaltungseinheiten der integrierten Schaltung störende Stromspitzen vermieden werden.

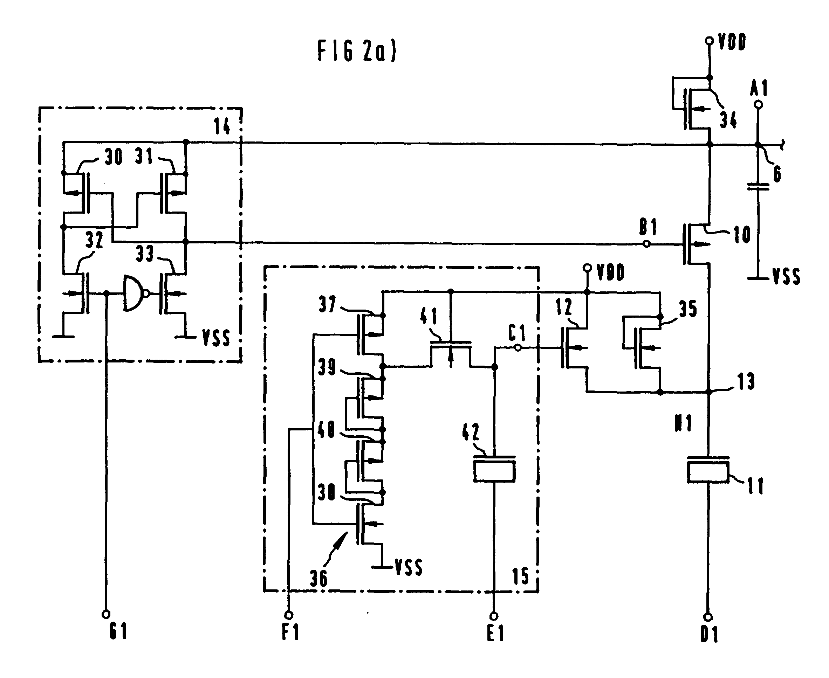

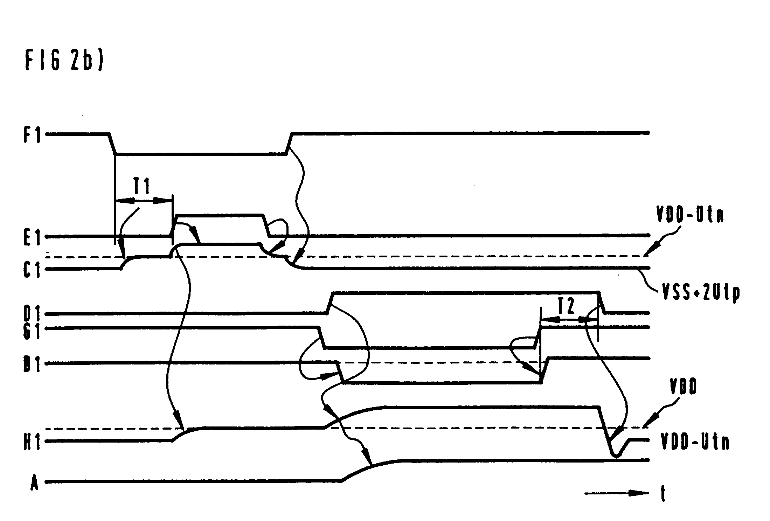

In der Figur 2 sind die Schaltungsblöcke 14, 15 in detaillierter schaltungstechnischer Realisierung zusammen mit dem Zeitverlauf der wesentlichen Signale bei einem Pumpvorgang der Schaltungshälfte 1 gezeigt. Für die Schaltungshälfte 2 ergibt sich die gleiche Realisierung mit zeitversetzten Signalen. Als Pegelwandler 14 zur Erzeugung des Signals B1 mit einem H-Pegel beim Ausgangspegel A und einem L-Pegel beim Versorgungspotential VSS wird ein kreuzgekoppelter Pegelwandler verwendet. Er enthält zwei Strompfade, die zwischen den Ausgangsanschluß 6 und das Versorgungspotential VSS geschaltet sind. Jeder der Strompfade enthält zwei p-Kanal-MOS-Transistoren 30, 31, deren Gate-Anschlüsse über Kreuz geschaltet sind. In Reihe dazu liegt jeweils ein n-Kanal-MOS-Transistor 32 bzw. 33. Einer der n-Kanal-MOS-Transistoren 32, 33 wird von einem Steuerungssignal G1, das in der Impulsformereinrichtung 4 erzeugt wird, gesteuert, der andere vom dazu komplementären Signal. Der Ausgang des Pegelumsetzers führt das Signal B1, mit dem der Transistor 10 gesteuert wird. Zur Vorladung der Speicherkapazität 5 ist ein als MOS-Diode geschalteter n-Kanal-MOS-Transistor 34 zwischen das Versorgungspotential VDD und den Ausgangsanschluß 6 geschaltet. Zur Vorladung der Schiebekapazität 11 ist in entsprechender Weise ein n-Kanal-MOS-Transistor 35 vorgesehen. Die Einrichtung 15 enthält einen Inverter 36, mit zwei komplementären Schalttransistoren 37, 38, bei dem zwischen den Ausgang des Inverters und den Drain-Anschluß des Transistors 38 zwei als MOS-Dioden geschaltete p-Kanal-MOS-Transistoren 39, 40 geschaltet sind. Der Eingang des Inverters 36 wird von einem von der Impulsformereinrichtung 4 erzeugten Steuersignal F1 gesteuert. Der Ausgang des Inverters 36 ist über einen Transfer-Transistor 41 mit dem Gate-Anschluß des Vorladetransistors 12 verbunden. Der Gate-Anschluß des Transistors 12 ist über eine Schiebekapazität 42 mit einem weiteren aus der Impulsformereinricntung 4 erzeugten Steuersignal El verbunden.

Zu Beginn eines Pumpzyklus werden zunächst die Speicherkapazität 5 und die Schiebekapazität 11 über die MOS-Dioden 34 bzw. 35 auf ein Potential VDD-Utn aufgeladen, wobei Utn die Schwellenspannung der Transistoren 34, 35 ist.

Gemäß dem in der Figur 2b dargestellten Signaldiagramm wird dann die Schiebekapazität 11 auf das Versorgungspotential VDD weiter aufgeladen, indem der Vorladetransistor 12 durch einen H-Pegel des Signals F1 leitend gesteuert wird, der höher als das Versorgungspotential VDD ist. Hierzu wird bei einer fallenden Flanke des Signals F1 der Ausgang des Inverters 36 mit dem Potential VDD verbunden. Die Schiebekapazität 42 wird dabei über den Transfer-Transistor 41 auf das Potential VDD - Utn vorgeladen, wobei Utn die Schwellenspannung des n-Kanal-MOS-Transistors 41 ist. Nach einer Zeitverzögerung T1 wird das Signal E1 auf einen H-Pegel umgeschaltet, und das Potential am Gate-Anschluß des Transistors 12 steigt über das Versorgungspotential VDD. Dabei sperrt der Transfer-Transistor 41. Somit wird die Schiebekapazität 11 vollständig auf das Potential VDD aufgeladen. Danacn fällt das Signal E1 wieder auf einen L-Pegel, wodurch das Signal C1 auf das Potential VDD - Utn fällt. Der Transistor 12 sperrt. Dann schaltet das Signal F1 auf H, so daß der Inverter 36 umschaltet. Dessen Ausgang ist nun über die beiden MOS-Dioden 39, 40 mit dem Potential VSS verbunden. Das Potential des Inverterausgangs beträgt somit VSS + 2 ^{•} Utp, wobei Utp die Einsatzspannung der p-Kanal-MOS-Transistoren 39, 40 ist. Damit wird erreicht, daß bei dem nachfolgenden Schiebevorgang an der Schiebekapazität 11 der Transistor 12 sicher sperrt, wobei gleichzeitig die maximale Gate-Source- oder Gate-Drain-Spannung am Transistor 12 reduziert wird. Der Schiebevorgang mit der Schiebekapazität 11 wird durch die Steuersignale D1, G1 eingeleitet. Durch das Signal D1 wird der Fußpunkt der Kapazität 11 auf das Potential VDD angehoben, mit dem Signal G1 wird nach Umsetzung durch den Pegelwandler 11 der Transistor 10 leitend gesteuert. Zweckmäßigerweise erfolgt die fallende Flanke des Signals G1 vor der steigenden Flanke des Signals D1, so daß der Transistor 10 gleichzeitig mit dem Potentialanstieg der Kapazität 11 leitet, wodurch Spannungsspitzen am Knoten 13 vermieden werden. Damit wird die Schiebekapazität 11 mit der Speicherkapazität 5 verbunden, so daß ein Ladungsausgleich stattfindet. Mit der steigenden Signalflanke des Signals G1 wird der Gate-Anschluß des Transistors 10 wieder auf das nun erhöhte Ausgangspotential A gelegt, so daß der Transistor 10 sperrt. Nach einer Zeitverzögerung T2 wird mit der fallenden Flanke des Signals D1 der Fußpunkt der Speicherkapazität 11 wieder auf das Potential VSS gelegt. Der Transistor 35 sorgt dafür, daß der Knoten 13 wieder auf das Potential VDD - Utn aufgeladen wird. Die Anstiegsrate des Signals H1 am Knoten 13 und die Anstiegsrate der Ausgangsspannung A am Knoten 6 sind kleiner als die Anstiegsrate des Signals B1. Dadurch ist es sichergestellt, daß der Transistor 10 schnell abgeschaltet werden kann.

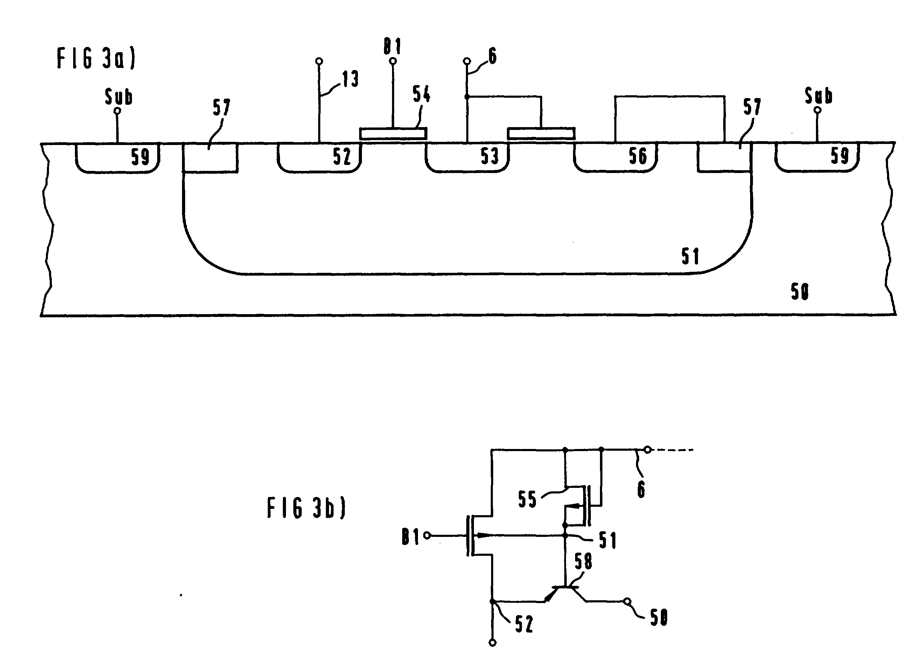

Der Aufbau eines der p-Kanal-Transistoren 10, 17 ist in Figur 3a im Schnitt, in Figur 3b als elektrisches Ersatzschaltbild gezeigt. Wie üblich wird bei DRAMs von einem p-leitfähigen Substrat 50 ausgegangen, in das zur Realisierung eines p-Kanal-MOS-Transistors eine n-Wanne 51 eingebracht ist. Die Transistoren 10, 17 werden dabei vorzugsweise in getrennten Wannen realisiert. Jeder der Transistoren besteht aus den Diffusionsgebieten 52, 53 mit einem dazwischen liegenden Gate 54. Die Wanne ist potentialmäßig nicht angeschlossen, d.h. weder an eines der Source- oder Drain-Gebiete noch an ein festes Potential, d.h. ihr Potential schwebt. Zweckmäßigerweise ist am Rand der Wanne 51 ein n-dotierter Guardring 57 angeordnet. Außerdem ist im Halbleitersubstrat 50 um die Wanne 51 ein weiterer Guardring 59, der an Substratpotential angeschlossen ist, angeordnet. Dadurcn werden eventuelle Ladungen seitlich abgesaugt. Die Wanne ist so zu dimensionieren, daß deren effektive Kapazität zu den anderen elektrischen Anschlüssen gering ist. Wenn das Potential des Knotens 13 über das Potential der Wanne 51 steigt, fließt ein Strom durch die Emitter-Basis-Diode des durch die Schichtenabfolge gebildeten pnp-Transistors 58 in die Wanne hinein. Damit steigt das Potential der Wanne. Bei einer geringen kapazitiven Belastung kann die Wanne schnell folgen, so daß der Spannungsabfall an der Emitter-Basis-Diode gering ist. Die Strominjektion in das Halbleitersubstrat wird minimiert, da der Bipolartransistor nur gering ausgesteuert wird. Die Strominjektion ins Substrat ist besonders bei DRAM-Bausteinen zu vermeiden, weil dadurch die in den Speicherzellen gespeicherte Information vernichtet werden kann. Das Potential der Wanne wird also nach dem Einscnalten der Ladungspumpe nach einigen Pumpzyklen aufgebaut. Danach bleiben die Diode und somit der pnp-Transistor gesperrt.

Um das Potential der Wanne nach oben zu begrenzen und ein unkontrolliertes Ansteigen des Wannenpotentials zu verhindern, was zu einer Abnahme der Leitfähigkeit des Transistors 10 bzw. 17 führen würde, ist ein weiterer p-Kanal-MOS-Transistor 55 vorgesehen. Der Transistor 55 ist als MOS-Diode zwischen die Wanne und den Ausgangsanschluß 6 geschaltet. Somit wird das Wannenpotential auf eine Einsatzspannung Utp des Transistors 55 über dem Ausgangssignal A begrenzt. Der Transistor 55 kann in platzsparender Weise durch ein zusätzliches Dotierungsgebiet 56 in der Wanne realisiert werden. Hierzu wird ein Transistorgate zwischen den Dotierungsgebieten 53, 56 angeordnet, das mit dem Ausgangsanschluß 6 verbunden ist. Das Dotierungsgebiet 56 ist mit dem Guardring 57 der Wanne verbunden.

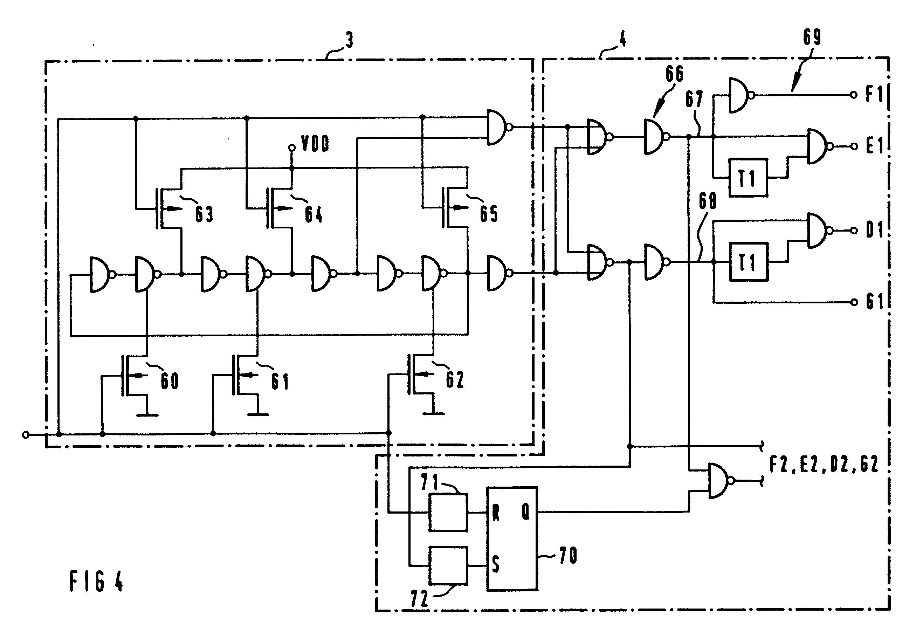

In der Figur 4 ist die Realisierung der Oszillatoreinrichtung 3 und der Impulsformereinrichtung 4 als logisches Blockdiagramm gezeigt. Der Oszillator 3 ist ein siebenstufiger Ringoszillator, der mit einem H-Pegel des Signals CTRL in einen vorbestimmten Anfangszustand freigegeben wird. Hierzu sind n-Kanal-MOS-Transistoren 60, 61, 62 vorgesehen, mit denen drei entsprechende Inverter des Ringoszillators mit Bezugspotential VSS verbunden werden. Zur schnellen Abschaltung des Ringoszillators sind drei p-Kanal-MOS-Transistoren 63, 64, 65 vorgesehen, die bei einem L-Pegel des Signals CTRL den Ausgang der entsprechenden Inverter mit dem Versorgungspotential VDD verbinden. Den Ausgängen des Ringoszillators nachgeschaltete Schaltungsmittel 66 erzeugen an den Knoten 67, 68 Impulsfolgen mit sich nicht überlappenden Impulsen. Durch weitere Schaltungsmittel 69, die den Knoten 67, 68 nachgeschaltet sind, werden unter Berücksichtigung von Verzögerungsleitungen mit der Verzögerung T1, T2 die Steuersignale F1, E1, D1, G1 zur Steuerung der Ladepumpenhälfte 1 erzeugt. Die Verzögerung T1 ist dabei die Verzögerung zwischen der fallenden bzw. der steigenden Signalflanke der Signale F1 und E2, die Verzögerung D2 ist die Verzögerung zwischen der steigenden bzw. der fallenden Signalflanke der Signale G1 und D1 (Figur 2b). Mit den invertierten Signalen der Knoten 67, 68 werden durch weitere, zu den Schaltungsmitteln 69 identische Schaltungsmittel die Steuersignale F2, E2, D1, G1 der Ladungspumpenhälfte 2 erzeugt. Damit das Pumpen der Ladungspumpe derart beginnt, daß zuerst ein Pumpvorgang der Ladungspumpe 1 und dann ein Pumpvorgang der Ladungspumpe 2 ausgeführt wird, ist ein RS-Flip-Flop 70 vorgesehen, das bei einer positiven Flanke des Signals CTRL rückgesetzt wird und bei einer negativen Flanke des am Anschluß 68 vorliegenden Signals gesetzt wird. Hierzu sind an den Reset- und Set-Eingängen des Flip-Flops 70 je ein Flankendetektor 71, 72 vorgesehen. Durch das Ausgangssignal des Flip-Flops 70 werden die ersten Impulse der Signale D2, G2 unterdrückt.

## Patentansprüche

1. Ladungspumpe mit den Merkmalen:
(a) eine Speicherkapazität (5) weist einen Anschluß für ein erstes Versorgungspotential (VSS) und einen weiteren Anschluß (6) zum Abgriff eines Ausgangspotentials (A) auf,
(b) ein Anschluß der Drain-Source-Strecke eines Transfer-MOS-Transistors (10), dessen Gate-Anschluß von einem ersten Signal (B1) gesteuert wird, ist mit dem weiteren Anschluß (6) der Speicherkapazität (5) verbunden,
(c) ein Anschluß einer Schiebekapazität (11) ist mit einem weiteren Anschluß der Drain-Source-Strecke des Transfer-MOS-Transistors (10) verbunden, und ein weiterer Anschluß der Schiebekapazität (11) wird von einem zweiten Signal (D1) gesteuert,
(d) die Drain-Source-Strecke eines n-Kanal-MOS-Transistors (12) ist zwischen ein zweites Versorgungspotential (VDD) und den Anschluß der Schiebekapazität (11) geschaltet und der Gate-Anschluß des n-Kanal-MDS-Transistors (12) wird von einem dritten Signal (C1) gesteuert,
und mit den Kennzeichnenden Merkmalen:
e) der Transfer-MOS-Transistor ist ein p-Kanal MOS-Transistor,
f) die Signale (B1, C1, D1) werden
durch eine von einer Oszillatoreinrichtung (3) gespeiste Impulsformereinricntung (4) derart erzeugt, daß der p-Kanal-MOS-Transistor (10) nur dann leitend ist, wenn das zweite Signal (D1) einen hohen Pegel hat, und daß der n-Kanal-MOS-Transistor (12) nur dann leitend ist, wenn das zweite Signal (D1) einen niedrigen Pegel hat.

2. Ladungspumpe nach Anspruch 1, **dadurch gekennzeichnet,** daß der hohe Pegel des ersten Signals (B1) beim Ausgangspotential (A) liegt, der niedrige Pegel beim ersten Versorgungspotential (VSS).

3. Ladungspumpe nach Anspruch 1 oder 2, **dadurch gekennzeichnet,** daß der hohe Pegel des dritten Signals (C1) höher als das zweite Versorgungspotential (VDD) liegt und der niedrige Pegel zwischen den Versorgungspotentialen (VDD, VSS).

4. Ladungspumpe nach einem der Ansprüche 1 bis 3, **dadurch gekennzeichnet,** daß zwischen den Anschluß der Schiebekapazität (11) und das zweite Versorgungspotential (VDD) ein als MOS-Diode geschalteter MOS-Transistor (35) geschaltet ist.

5. Ladungspumpe nach einem der Ansprüche 1 bis 4, **dadurch gekennzeichnet,** daß zwischen den weiteren Anschluß (6) der Speicherkapazität (5) und das zweite Versorgungspotential (VDD) ein als MOS-Diode geschalteter MOS-Transistor (34) geschaltet ist.

6. Ladungspumpe nach Anspruch 2, **dadurch gekennzeichnet,** daß zur Erzeugung der Pegel des ersten Signals (B1) ein kreuzgekoppelter Pegelkonverter (14) vorgesehen ist, der vom Ausgangspotential (A) und dem ersten Versorgungspotential (VSS) mit Spannung versorgt wird und der eingangsseitig mit der Impulsformereinrichtung (4) und ausgangsseitig mit dem Gate-Anschluß des p-Kanal-MOS-Transistors (10) verbunden ist.

7. Ladungspumpe nach Anspruch 3, **dadurch gekennzeichnet,** daß zwischen den Gate-Anschluß des n-Kanal-MOS-Transistors (12) und die Impulsformereinrichtung (4) eine weitere Schiebekapazität (42) geschaltet ist, daß der Gate-Anschluß des n-Kanal-MOS-Transistors (12) über ein Transfer-Gatter (41) mit dem Ausgang eines Inverters (36) verbunden ist, daß der Inverter (36) eingangsseitig mit der Impulsformereinrichtung (4) verbunden ist und daß zwischen den Ausgang des Inverters (36) und den Drain-Anscnluß eines an das erste Versorgungspotential (VSS) angeschlossenen Schalttransistors (38) des Inverters (36) mindestens ein als MOS-Transistor geschalteter p-Kanal-MOS-Transistor (40, 39) geschaltet ist.

8. Ladungspumpe nach einem der Ansprüche 1 bis 7,**dadurch gekennzeichnet**, daß der p-Kanal-MOS-Transistor (10) in einer n-dotierten Wanne (51) in einem p-dotierten Halbleitersubstrat (50) angeordnet ist, daß die Wanne (51) auf schwebendem Potential liegt und daß die Wanne (51) einen Guardring (57) aufweist.

9. Ladungspumpe nach Anspruch 8, **dadurch gekennzeichnet,** daß die Wanne (51) des p-Kanal-MOS-Transistors (10) über einen als MOS-Diode geschalteten p-Kanal-MOS-Transistor (55), der in der Wanne angeordnet ist, an das Ausgangspotential (A) angeschlossen ist.

10. Ladungspumpe nach Anspruch 9, **dadurch gekennzeichnet,** daß der Oszillator ein Ringoszillator ist, der mittels eines Steuersignals (CTRL) abschaltbar ist und der beim Einschalten mit einer vorbestimmten Phasenlage beginnt zu schwingen.

11. Ladungspumpe nach einem der Ansprüche 1 bis 10, **gekennzeichnet durch** Gegentaktausführung mit zwei an den weiteren Anschluß (6) der Speicherkapazität (5) angeschlossenen Ladungspumpen, die von Gegentaktsignalen gesteuert werden.

## Claims

1. Charge pump having the following features:
(a) a storage capacitor (5) has a terminal for a first supply potential (VSS) and a further terminal (6) for the tapping of an output potential (A),
(b) a terminal of the drain-source path of a transfer MOS transistor (10), whose gate terminal is controlled by a first signal (B1), is connected to the further terminal (6) of the storage capacitor (5),
(c) a terminal of a shift capacitor (11) is connected to a further terminal of the drain-source path of the transfer MOS transistor (10), and a further terminal of the shift capacitor (11) is controlled by a second signal (D1),
(d) the drain-source path of an n-channel MOS transistor (12) is connected between a second supply potential (VDD) and the terminal of the shift capacitor (11) and the gate terminal of the n-channel MOS transistor (12) is controlled by a third signal (C1),
and having the following characterizing features:
(e) the transfer MOS transistor is a p-channel MOS transistor,
(f) the signals (B1, C1, D1) are generated by a pulse shaper device (4), which is fed by an oscillator device (3), in such a way that the p-channel MOS transistor (10) is in the on state only when the second signal (D1) has a high level, and that the n-channel MOS transistor (12) is in the on state only when the second signal (D1) has a low level.

2. Charge pump according to Claim 1, characterized in that the high level of the first signal (B1) has the value of the output potential (A) and the low level has the value of the first supply potential (VSS).

3. Charge pump according to Claim 1 or 2, characterized in that the high level of the third signal (C1) is higher than the second supply potential (VDD) and the low level lies between the supply potentials (VDD, VSS).

4. Charge pump according to one of Claims 1 to 3, characterized in that a MOS transistor (35) connected as MOS diode is connected between the terminal of the shift capacitor (11) and the second supply potential (VDD).

5. Charge pump according to one of the Claims 1 to 4, characterized in that a MOS transistor (34) connected as MOS diode is connected between the further terminal (6) of the storage capacitor (5) and the second supply potential (VDD).

6. Charge pump according to Claim 2, characterized in that a cross-coupled level converter (14) is provided for the purpose of generating the levels of the first signal (B1), which level converter is supplied with voltage by the output potential (A) and the first supply potential (VSS) and, on the input side, is connected to the pulse shaper device (4) and, on the output side, is connected to the gate terminal of the p-channel MOS transistor (10).

7. Charge pump according to Claim 3, characterized in that a further shift capacitor (42) is connected between the gate terminal of the n-channel MOS transistor (12) and the pulse shaper device (4), in that the gate terminal of the n-channel MOS transistor (12) is connected to the output of an invertor (36) via a transfer gate (41), in that the invertor (36) is connected, on the input side, to the pulse shaper device (4), and in that at least one p-channel MOS transistor (40, 39) connected as MOS transistor is connected between the output of the invertor (36) and the drain terminal of a switching transistor (38) of the invertor (36), which switching transistor is connected to the first supply potential (VSS).

8. Charge pump according to one of Claims 1 to 7, characterized in that the p-channel MOS transistor (10) is arranged in an n-doped well (51) in a p-doped semiconductor substrate (50), in that the well (51) is at floating potential, and in that the well (51) has a guard ring (57).

9. Charge pump according to Claim 8, characterized in that the well (51) of the p-channel MOS transistor (10) is connected to the output potential (A) via a p-channel MOS transistor (55), which is connected as MOS diode and is arranged in the well.

10. Charge pump according to Claim 9, characterized in that the oscillator is a ring oscillator which can be switched off by means of a control signal (CTRL) and which begins to oscillate with a predetermined phase angle when switched on.

11. Charge pump according to one of Claims 1 to 10, characterized by push/pull implementation with two charge pumps which are connected to the further terminal (6) of the storage capacitor (5) and are controlled by push/pull signals.

## Revendications

1. Pompe à charge comportant les dispositions :
(a) une capacité (5) de mémoire comporte une borne pour un premier potentiel (VSS) d'alimentation et une borne (6) supplémentaire pour prélever un potentiel (A) de sortie,
(b) une borne de la section drain-source d'un transistor (10) MOS de transfert, dont la borne de grille est commandée par un premier signal (B1), est reliée à la borne (6) supplémentaire de la capacité (5) de mémoire,
(c) une borne d'une capacité (11) de décalage est reliée à une borne supplémentaire de la section drain-source du transistor (10) MOS de transfert, et une borne supplémentaire de la capacité (11) de décalage est commandée par un deuxième signal (D1),
(d) la section drain-source d'un transistor (12) MOS à canal n est branchée entre un deuxième potentiel (VDD) d'alimentation et la borne de la capacité (11) de décalage et la borne de grille du transistor (12) MOS à canal n est commandée par un troisième signal (C1),
et comportant les dispositions caractéristiques :
(e) le transistor MOS de transfert est un transistor MOS à canal p,
(f) les signaux (B1, C1, D1) sont produits par un dispositif (4) de mise en forme d'impulsions, alimenté par un dispositif (3) oscillateur, de telle manière que le transistor (10) MOS à canal p n'est passant que si le deuxième signal (D1) a un niveau haut et de telle manière que le transistor (12) MOS à canal n n'est passant que si le deuxième signal (D1) a un niveau bas.

2. Pompe à charge suivant la revendication 1, caractérisée en ce que le niveau haut du premier signal (B1) est au potentiel (A) de sortie, le niveau bas au premier potentiel (VSS) d'alimentation.

3. Pompe à charge suivant la revendication 1 ou 2, caractérisée en ce que le niveau haut du troisième signal (C1) est supérieur au deuxième potentiel (VDD) d'alimentation et le niveau bas compris entre les potentiels (VDD, VSS) d'alimentation.

4. Pompe à charge suivant l'une des revendications 1 à 3, caractérisée en ce qu'il est branché un transistor (35) MOS branché en diode MOS entre la borne de la capacité (11) à décalage et le deuxième potentiel (VDD) d'alimentation.

5. Pompe à charge suivant l'une des revendications 1 à 4, caractérisée en ce qu'il est branché un transistor MOS (34) branché en diode MOS entre la borne (6) supplémentaire de la capacité (5) de mémoire et le deuxième potentiel (VDD) d'alimentation.

6. Pompe à charge suivant la revendication 2, caractérisée en ce que, pour produire le niveau du premier signal (B1), il est prévu un convertisseur (14) de niveau couplé en croix, qui est alimenté en tension par le potentiel (A) de sortie et par le premier potentiel (VSS) d'alimentation et qui est relié côté entrée au dispositif (4) de mise en forme d'impulsions et côté sortie à la borne de grille du transistor (10) MOS à canal p.

7. Pompe à charge suivant la revendication 3, caractérisée en ce qu'il est branché une capacité (42) de décalage supplémentaire entre la borne de grille du transistor (12) MOS à canal n et le dispositif (4) de mise en forme d'impulsions, en ce que la borne de grille du transistor (12) MOS à canal n est reliée, par l'intermédiaire d'une grille (41) de transfert, à la sortie d'un inverseur (36), en ce que l'inverseur (36) est relié côté entrée au dispositif (4) de mise en forme d'impulsions et en ce qu'il est branché entre la sortie de l'inverseur (36) et la borne de drain d'un transistor (38) de commutation, raccordé au premier potentiel (VSS) d'alimentation, de l'inverseur (36) au moins un transistor (40, 39) MOS à canal p branché en transistor MOS.

8. Pompe à charge suivant l'une des revendications 1 à 7, caractérisée en ce que le transistor (10) MOS à canal p est monté dans un puits (51) à dopage n, dans un substrat (50) semi-conducteur à dopage p, en ce que le puits (51) est à un potentiel flottant, et en ce que le puits (51) comporte un anneau (57) de garde.

9. Pompe à charge suivant la revendication 8, caractérisée en ce le puits (51) du transistor (10) MOS à canal p est raccordé au potentiel (A) de sortie par l'intermédiaire d'un transistor (55) MOS à canal p qui est branché en diode MOS et qui est monté dans le puits.

10. Pompe à charge suivant la revendication 9, caractérisée en ce l'oscillateur est un oscillateur annulaire qui peut être débranché au moyen d'un signal (CTRL) de commande et qui, lorsqu'on le branche, commence à osciller en ayant une relation de phase prédéterminée.

11. Pompe à charge suivant l'une des revendications 1 à 10, caractérisée par une réalisation symétrique comportant deux pompes à charge qui sont raccordées à la borne (6) supplémentaire de la capacité (5) de mémoire et qui sont commandées par des signaux symétriques.
